(19) Europäisches Patentamt
European Patent Office
Office européen des brevets

(11) Publication number: **0 067 132**
**B1**

(12) **EUROPEAN PATENT SPECIFICATION**

(45) Date of publication of patent specification: **07.09.88**

(51) Int. Cl.$^4$: **H 03 F 3/191,** H 03 F 1/34, H 03 F 1/30

(21) Application number: **82830122.6**

(22) Date of filing: **07.05.82**

(54) **Improvement in bipolar transistor amplifiers with a high linear dynamic range.**

(30) Priority: **29.05.81 IT 4858081**

(43) Date of publication of application:
**15.12.82 Bulletin 82/50**

(45) Publication of the grant of the patent:
**07.09.88 Bulletin 88/36**

(84) Designated Contracting States:
**DE FR GB NL SE**

(56) References cited:
**DE-A-1 762 792**
**US-A-3 903 479**
**ELECTRONICS, vol. 46, no. 21, 11th October 1973, pages 105-106, McGraw-Hill, New York (USA); P. ANTONIAZZI: "CATV transistors function as low-distortion vhf preamplifiers".**
**IEEE JOURNAL OF SOLID-STATE CIRCUITS, vol. SC-7, no. 2, April 1972, pages 168-170, New York (USA); W.J. HOFF: "Optimum design techniques for micropower circuitry".**
**NUCLEAR INSTRUMENTS AND METHODS, vol. 72, no. 3, 1st August 1969, pages 314-316, Amsterdam (NL); K. WILLE: "Ein schneller de-Verstärker mit stabilisierung des Ruhepotentials".**

(73) Proprietor: **SELENIA INDUSTRIE ELETTRONICHE ASSOCIATE S.p.A.**
**Via Tiburtina, KM 12.400**
**I-00131 Roma (IT)**

(72) Inventor: **Cozzi, Gianfranco**
**Via C. Dossi**
**I-00100 Roma (IT)**

(74) Representative: **Gustorf, Gerhard, Dipl.-Ing.**
**Patentanwalt Dipl.-Ing. Gerhard Gustorf**
**Mühlenstrasse 1**
**D-8300 Landshut (DE)**

EP 0 067 132 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

The present invention relates to an amplifying circuit for high-frequency signals, comprising a bipolar amplifying transistor with a base connected to a signal source, a collector connected through a load circuit to one terminal of a DC power supply, and an emitter connected to the first terminal of a first resistor, which is part of a feedback circuit including said first resistor and a capacitor connecting said emitter with ground.

When the base of a bipolar transistor operating in the common-emitter-mode receives high-frequency signals, a faithful reproduction requires a linear relationship between the amplitude of the fundamental frequency of the input signal and the output signal.

There are known several means intended to increase the dynamic range within which such linear relationship is maintained. Generally, such means provide a feedback in current or voltage. A resistor inserted between the emitter of the amplifying transistor and circuit grounds establishes an operating point in the middle of the required dynamic range with the aid of a voltage drop generated by said resistor. A large feedback resistor, however, reduces the gain of the amplifier stage and necessitates a relatively high gain in a subsequent stage. Thereby the noise figure of the amplifier is enhanced.

Voltage feedback, as by the insertion of a resisted connection between collector and base of the amplifying transistor, significantly reduces the gain and worsens the noise figure.

In accordance with the pre-characterizing clause of claim 1, as outlined above, DE—A—17 62 792 discloses an amplifier circuit comprising a capacitor and a first resistor. The capacitor is intended to shunt the resistor at high frequencies. At relatively low frequencies, however, the feedback resistor still reduces the gain of the amplifier stage if it has a considerable resistance value.

The problem underlying the present invention is to provide amplifiying circuit of the type mentioned above having a convenient noise figure and a wide dynamic range.

In accordance with the characterizing part of claim 1, this problem is solved in that a second resistor is connected between the second terminal of said first resistor and said other terminal of the DC power supply, said second resistor having a resistance value which is relatively high with respect to that of the first resistor, and in that circuit means independent of the amplifying transistor and the first resistor are connected to the junction of the resistors for biasing the junction of the resistors to an intermediate potential between those of said power supply terminals.

Whereas the prior art teaches to use a feedback resistor connected between the emitter of the amplifying transistor and circuit ground, the present invention teaches to use a series connection of a resistor having a low resistance value and a resistor having a high resistance value, wherein circuit means are provided to maintain the potential at the junction between said two resistors at an intermediate value between the potential values of the power supply terminals. Thereby, a substantially constant mean voltage drop across the low-ohmic resistor is maintained. As a consequence, there is only a relatively small reduction of gain of the amplifier due to the feedback resistor, while the amplifying circuit is characterized by a wide dynamic range. The second resistor having a relatively high resistance value is a stabilizing resistor. The series connection of the two resistors is shunted by the capacitor.

The invention will now be described in detail with reference to the accompanying drawings in which

Fig. 1 diagrammatically shows a transistor stage of an amplifier provided with conventional current feedback;

Fig. 2 is a similar diagram showing a transistor stage provided with conventional voltage feedback;

Fig. 3 is a diagram showing a transistor stage forming part of an amplifier according to the present invention, and

Fig. 4 is a circuit diagram showing the transistor stage of figure 3 in connection with additional components of the amplifying circuit of the present invention.

In order to facilitate the understanding of the present invention, there will now be described the prior art feedback circuit. The circuitry shown in Fig. 3 is known from Electronics October 11, 1973, pages 105, 106. With reference to Figs. 1 and 2, there will be described two ways for obtaining a feedback.

The first way consists in inserting an ohmic resistance in series with the emitter connection as shown in Fig. 1.

The effect of the emitter resistance $R_F$ can be explained in terms of the linearising effect due to current feedback for the case of the common emitter configuration. The value of the bias current must be such as to produce a voltage drop across the resistor $R_F$ a little greater than the maximum peak input voltage. This is so that the minimum input voltages do not coincide with the transistor cut-off which would result in a consequent loss of linearity. Therefore, it is seen how for large input signals $V_{IN}$ either relatively high bias resistances or currents are necessary to satisfy the relationship referred to above, i.e.

$$R_F \cdot I_{DC} > V_{IN}$$

However, making the value of these two factors high results in a worsening of the amplifier noise figure.

In fact, the increase in the value of the resistance $R_F$ directly worsens the noise figure of the first stage, and, due to the reduction of gain resulting from the feedback (or in the common base configuration resulting from the increase of generator impedance) increases the noise contribution of the second stage to the total noise figure.

The increase of the bias current increases the noise figure because of the so-called "collector term" whose contribution increases with the current (and with the frequency).

The second way consists in the use of a feedback voltage between the output and the input of the same stage so as to present a relatively low input resistance to the generator and therefore attenuate the signal applied effectively to the base-emitter junction. Refer to Figure 2.

Also in this case there are disadvantages: for one thing a reduction of gain with the increase of the noise contribution of the successive stages, further a worsening of the noise figure corresponding approximately to that due to the feedback resistance $R_F$ but placed between the input and earth, and finally difficulties in realizing a connection of this type.

In the known devices for obtaining large input dynamic ranges, there is always a more or less large loss of sensitivity in the amplifier stage. This is particularly serious in the first stage of the low-noise preamplifiers for radio frequency signals (Radar, Telecommunications, etc.)

In this invention, with reference to Fig. 3, the transistor amplifier is associated with a bias circuit in which, by means of a direct current feedback, for an increase of the mean emitter (or collector) current there is a corresponding variation of the input signal bias voltage in such a direction as to oppose the said current variation so reducing the intensity of it and maintaining the changes of proportionality between the fundamental components (first harmonic) of the input and output signals within the narrow limits desired.

A quantitative theoretical analysis of distortion phenomena in a transistor (made on the assumption that the relationship between the collector current and the base-emitter voltage is as follows:

$$i_s = i_{si}(e\frac{V_{BE}}{V_T} - 1)$$

with

$$V_T \frac{KT}{q},$$

q=electron charge and $i_{si}$=inverse saturation current) will allow the choice of the resistance that, inserted in series in the emitter bias circuit and therefore in direct current realizes the said self-biasing of the input signal.

Fig. 3 shows a typical, but not unique, bias circuit with reference to which this invention will be described.

From a qualitative point of view, the positive results furnished by the arrangement in the invention can be justified by the following considerations. If the resistance $R_E$ on the emitter is very large, i.e. if the voltage drop $R_E \cdot I_{DC}$ is many times greater than the variations of $V_{BE}$ envisaged for any conditions (temperature, degradation of the parameters, signal level, etc.) there would be a very large current feed back such as to render $I_{DC}$ practically invariable.

Under these conditions the quantitative theoretical analysis previously mentioned allows to derive the fact that due to the large self-bias voltage of the input signal which occurs when the signals are not much less than $V_T$=25—50 mV there is a displacement of 1 dB from the constancy of the amplitude ratios between the fundamentals of input and output especially for $V_{IN} \simeq V_T$ that corresponds numerically to a dynamic range of about 83 dB on the noise for an $R_g$=50 Ohm B=1 MHz, NF=3 dB.

If the resistance $R_E$ is nil (and that corresponds to a voltage bias) difficulty would be encountered in the current stabilization of the emitter and therefore in the gain of the transistor.

If these difficulties would be overcome, from the analysis it may be derived that an expansion would be obtained with the increase of the input signal and that this would achieve the value of 1 dB of the output with respect to the input still for $V_{IN} \simeq V_T$.

At this point it is evident, and it is also confirmed by the mathematical analysis of the phenomenon, that for an intermediate value of $R_F$, with the increase of the input signal, a limited compression would be obtained followed then by an expansion.

What counts is that now we may obtain the maximum displacement, e.g. 1 dB from linearity for values of $V_{IN}$ that reach the value of several $V_T$. Still within the limits of simplified theoretical analysis we have in particular that $V_{INmax}$=37 $V_T$ for a maximum displacement from linearity of ±1 dB.

In practice the behaviour is favourable because factors such as $R_{EE}$, $h_{fc}$, $R_G$ are opposed to the final expansion ($R_{EE}$ being the ohmic resistance of the emitter-base junction; $h_{fc}$ the amplification of collector-base current for small signals; $R_G$ the generator resistance). The factors which have an effect of further linearization especially for the values of $V_I$ which exceed the theoretical ones envisaged by the simplified theory.

In fact $R_{EE}$ does not have much effect while it is less than $V_{T/I}$; e.g. if $R_{EE}$=1 Ohm up o about $i_c$=25 mA.

Above these values it reduces the peaks of the current with respect to the approximate theoretical value thus reducing also the fundamental component at the output. On the reduction of $h_{fe}$ for high values of $i_c$ there is a reduction, if somewhat less, of α with it, that of the collector current for an equal emitter current.

A value of $R_G$ which is not nil causes the non-proportional reduction of the voltage peaks on the base resulting from the non linear increase of the emitter peak current associated with the duction of $h_{fe}$.

This phenomenon, as for the effect of $R_{EE}$, is sensitive only to high values of instantaneous emitter current.

The result of these factors is that proportionality of the envelope of the input and output fundamentals is easily obtainable within a limit of 1 dB (with $R_G$=50 Ohm) of the order of 0—10 dBm corresponding to a dynamic range of about 110—120 dB, therefore more than 30 dB greater than that obtainable with conventional chniques.

The technique of biassing described up to now cannot be separated from the use of a special voltage source $V_{EE}$ (in the typical solution).

The source must overcome the disadvantage of an amplifier idle current $I_{OR}$ which is very variable with the ambient temperature $T_A$.

The said variability is due to the temperature coefficient of the base-emitter voltage (2 mV/°K) combined with the low value (a few tens of ohms) of the resistance $R_E$ interposed between the emitter and source of $V_{EE}$. Typically there would be a variation of about

$$\frac{20\text{ mV}}{35\Omega}=0.57\text{ mA}$$

for every 10° of variation $T_A$, which is excessive for currents of the order of 1 mA. The source $V_{EE}$ must therefore supply an EMF with a temperature coefficient which is within the tolerance necessary for the base-emitter junction of the amplifier transistor. Its internal impedance must, however, be less than the required $R_E$.

By way of example a solution is proposed which is both simple and effective. See Fig. 4.

Transistor $Q_2$ is biased with a greater current than the maximum d.c. (with signal) of $Q_1$. Transistor $Q_3$ is biased to the same steady-state current as $Q_1$.

Diode $D_1$ is biased via $R_1$ to a current of the same order as that of $Q_2$. The variable resistance $R_2$ adjusts the value of $V_{EE}$.

Transistors $Q_1$, $Q_2$ and $Q_3$ are of the same type; $Q_1$ and $Q_3$ tend to compensate each other by passing the same current and the same occurs with $Q_2$ and $D_1$.

Transistors $Q_3$ and $D_1$ are necessary since by design the current in $Q_2$ is much greater than that of $Q_1$ and for this reason there are different temperature coefficients.

The substance of the invention thus consists in providing a transistor with the function of an amplifier biased with special criteria and by means of a voltage source with parameters dependent on the temperature of the ambient.

In this way, for the same noise figure, we obtain dynamic ranges in an amplifier stage much greater (about 30 dB) than with the conventional techniques.

The circuit in Fig. 4 gives typical values of the power supply voltages, the voltages which appear in the significant nodes of the circuit, the currents which flow in the significant nodes of the circuit and typical values of the passive components. The values of the passive components (resistors) are optimized for bipolar transistors of the BFR 92 Philips type.

From that point of view of technical realization, apart from the obvious construction technique with discrete components, the integrated realization with hybrid film circuits or monoliths of the complex $Q_1$, $Q_2$, $Q_3$, $D_1$, $R_E$, $R_1$, $R_2$, $R_3$, $R_4$, $R_5$, $R_6$, $C_1$, $C_2$ is to be considered particularly advantageous with saving in costs, reduction in size and better matching of the junction temperatures to achieve correct functioning.

The circuit according to this invention is particularly suited to the realization of low noise amplifier stages with a high dynamic range for receivers for radar systems, telecommunications systems and the like.

The circuit according to this invention can also be utilized in general amplification stages in which it is desired to obtain at the same time a high gain, a high degree of linearity and a reduced dissipation. The above applies to signals with amplitude modulated carries on band-pass channels.

**Claims**

1. An amplifying circuit for high-frequency signals, comprising a bipolar amplifying transistor ($Q_1$) with a base connected to a signal source, a collector connected through a load circuit to one terminal of a DC power supply, and an emitter connected to the first terminal of a first resistor ($R_E$), which is part of a feedback circuit including said first resistor ($R_E$) and a capacitor ($C_1$) connecting said emitter with ground, characterized in that a second resistor ($R_3$) is connected between the second terminal of said first resistor ($R_E$) and said other temrinal of the DC power supply, said second resistor ($R_3$) having a resistance value which is relatively high with respect to that of the first resistor ($R_E$), and in that circuit means ($Q_2$, $Q_3$, $D_1$) independent of the amplifying transistor ($Q_1$) and the first resistor ($R_E$) are connected to the junction of the resistors ($R_3$, $R_E$) for biasing the junction of the resistors ($R_E$, $R_3$) to an intermediate potential between those of said power supply terminals.

2. An amplifying circuit as in claim 1, wherein said two power supply terminals have potentials balanced with reference to ground.

3. An amplifying circuit as in claim 2, wherein the capacitor ($C_1$) is connected between the emitter of the amplifying transistor ($Q_1$) and ground, while an additional capacitor is connected between ground and the other power supply terminal.

**Patentansprüche**

1. Verstärkerschaltung für Hochfrequenzsignale mit einem bipolaren Verstärkungstransistor ($Q_1$) mit einer an eine Signalquelle angeschlossenen Basis, einem über eine Lastschaltung an eine Klemme einer Gleichspannungsleistungsversorgung angeschlossenem Kollektor und einem an die erste Klemme eines ersten Widerstandes ($R_E$) geschlossenen Emitter, der einen Teil einer Rückkopplungschaltung mit dem ersten Widerstand ($R_E$) und einem Kondensator ($C_1$), der den Emitter mit Masse verbindet, darstellt, dadurch gekennzeichnet, daß ein zweiter Widerstand ($R_3$) zwischen der zweiten Klemme des ersten Widerstandes ($R_E$) und der anderen Klemme der Gleichspannungsleistungsversorgung angeschlossen ist, wobei der zweite Widerstand ($R_3$) einen Widerstandswert hat, der relativ hoch bezüglich desjenigen des ersten Widerstandes ($R_E$) ist, und daß Schaltungseinrichtungen ($Q_2$, $Q_3$, $D_1$), die unabhängig von dem Verstärkungstransitor ($Q_1$) und dem ersten Widerstand ($R_F$) sind, an den Verbindungspunkt der Widerstände ($R_3$, $R_E$) angeschlossen sind, um den Verbindungspunkt der Widerstände ($R_E$, $R_3$) auf ein Mittenpotential zwische den Potentialen der Leistungsversorgungsklemmen vorzuspannen.

2. Verstärkerschaltung nach Anspruch 1, bei der die beiden Leistungsversorgungsklemmen bezüglich Masse ausgeglichene Potentiale haben.

3. Verstärkerschaltung nach Anspruch 2, bei der der Kondensator ($C_1$) verbunden ist zwischen dem Emitter des Verstärkungstransistors ($Q_1$) und Masse, während eine weiterer Kondensator zwischen Masse und der anderen Leistungsversorgungsklemme geschaltet ist.

**Revendications**

1. Circuit d'amplification pour signaux à haute fréquence, comprenant un transistor ($Q_1$) amplificateur bipolaire comportant une base reliée à une source de signaux, un collecteur relié par un circuit de charge à une des bornes d'une alimentation en courant continu, et un émetteur relié à la première borne d'une première résistance ($R_E$) qui constitue une partie d'un circuit de réaction comprenant ladite première résistance ($R_E$) et un condensateur ($C_1$) reliant ledit émetteur à la terre, caractérisé en ce qu'une seconde résistance ($R_3$) est branchée entre la seconde borne de ladite première résistance ($R_E$) et l'autre borne de ladite alimentation en courant continu, ladite seconde résistance ($R_3$) ayant une valeur nominale de résistance qui est relativement élevée par rapport à celle de la première résistance ($R_E$) et en ce que ces moyens de circuit ($Q_2$, $Q_3$, $D_1$) indépendants du transistor amplificateur ($Q_1$) et de la première résistance ($R_E$) sont reliés à la jonction entre les résistances ($R_3$ et $R_E$) en vue de dépolariser la fonction .des résistance ($R_E$, $R_3$) à un potentiel intermédiaire entre ceux desdites bornes de l'alimentation en courant électrique.

2. Circuit d'amplification selon la revendication 1, dans lequel lesdites deux bornes de l'alimentation en courant électrique ont des potentiels qui s'équilibrent par rapport à la terre.

3. Circuit d'amplification selon la revendication 2, dans lequel le condensateur ($C_1$) est branché entre l'émetteur du transistor ($Q_1$) amplificateur et la terre, un condensateur supplémentaire étant branché entre la terre et l'autre borne de l'alimentation en courant électrique.

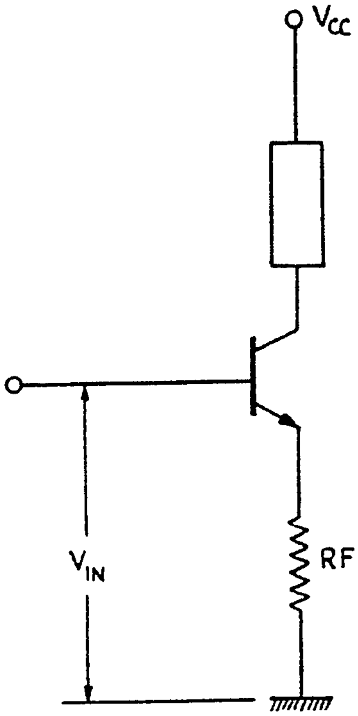


Fig. 1

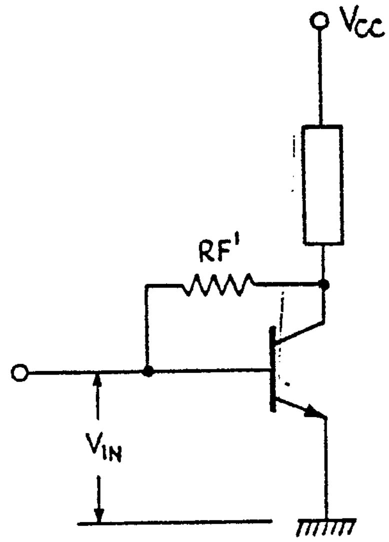


Fig. 2

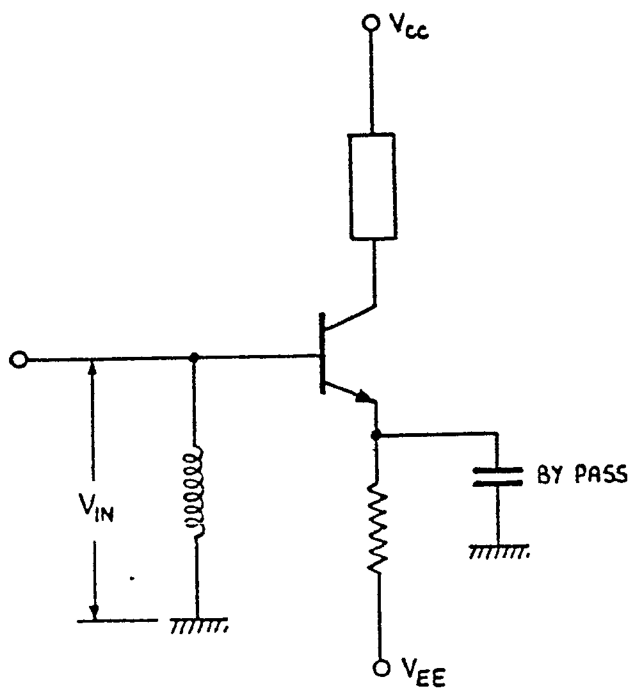


Fig. 3

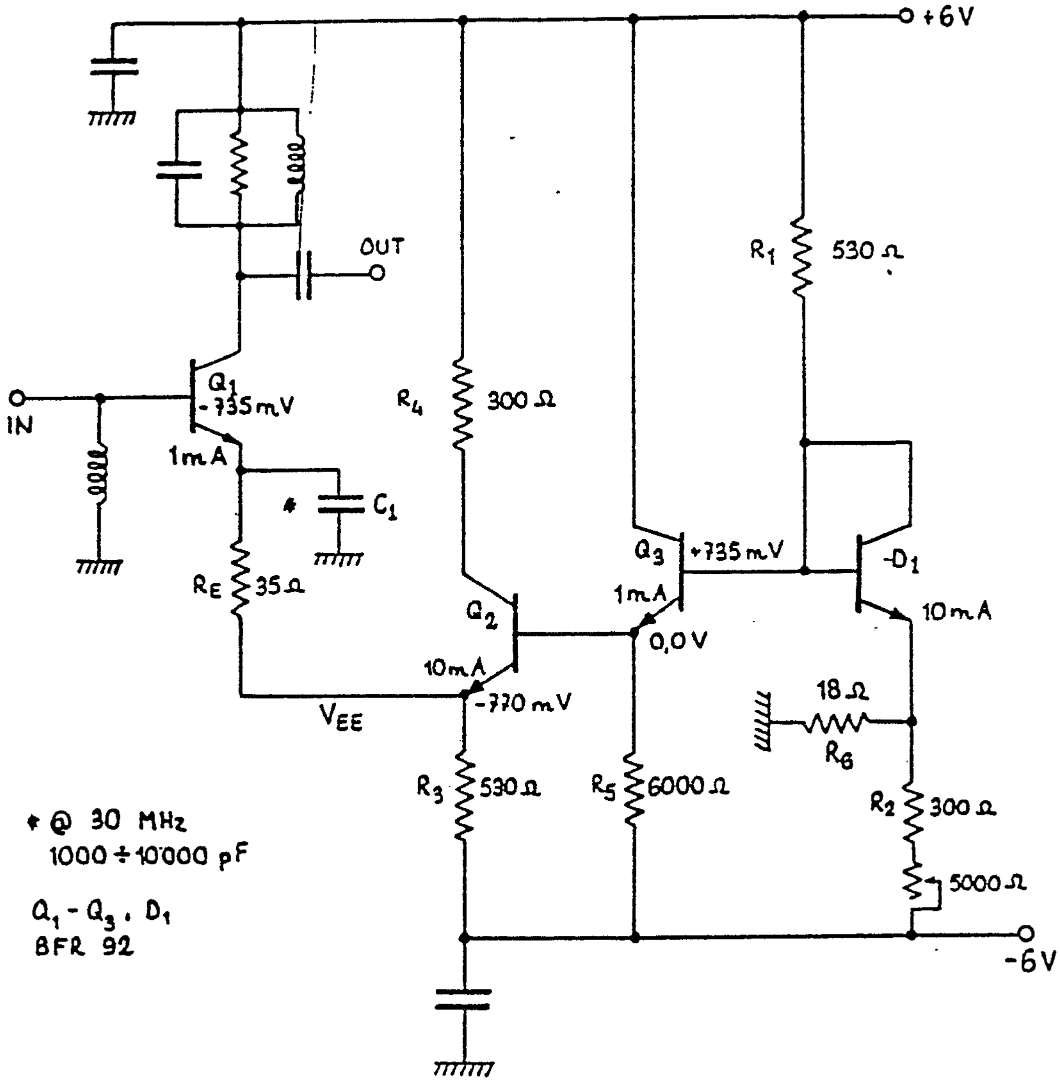
+6V
OUT
IN
Q1
-735mV
1mA
C1
RE
35Ω
R4
300 Ω
R1
530 Ω
Q2
10mA
-770 mV
VEE
Q3
+735 mV
1mA
0,0 V
D1
10 mA
18 Ω
R6
R3
530 Ω
R5
6000 Ω
R2
300 Ω
5000 Ω
-6V
* @ 30 MHz
1000 ÷ 10'000 pF
Q1 - Q3 , D1
BFR 92

*Fig. 4*